# EUROPÄISCHE PATENTSCHRIFT

(11) **EP 1 930 945 B1**
(45) Veröffentlichungstag und Bekanntmachung des Hinweises auf die Patenterteilung: **20.05.2009**
(21) Anmeldenummer: 07023366.3
(22) Anmeldetag: 03.12.2007
(51) Int. Cl.: H01L 23/48, H01L 25/07

(54) **Leistungshalbleitermodul**
Semiconductor power module
Module semi-conducteur de puissance

(30) Priorität: 05.12.2006 DE 102006057248
(43) Veröffentlichungstag der Anmeldung: 11.06.2008
(73) Patentinhaber: SEMIKRON Elektronik GmbH & Co. KG, 90431 Nürnberg (DE)
(72) Erfinder: Lederer, Marco, 90453 Nürnberg (DE); Popp, Rainer, 91580 Petersaurach (DE); Bogen, Ingo, 90403 Nürnberg (DE); Ebersberger, Frank, 90518 Altdorf (DE); Steger, Jürgen, 91355 Hilpoltstein (DE)

(56) Entgegenhaltungen:
- EP-A- 0 776 042
- WO-A-20/05048347
- DE-A1-6102004 061 93
- DE-A1-5102006 006 42

## Beschreibung

Die Erfindung betrifft ein Leistungshalbleitermodul mit einem Gehäuse und mindestens einem mit Halbleiterbauelementen bestückten Modulplattenelement, das mit Last- und Hilfsanschlusselementen druckkontaktiert ist, wobei die Lastanschlusselemente aufeinander angeordnete und gegeneinander elektrisch isolierte Bandabschnitte und von diesen in die gleiche Richtung wegstehende Kontaktfüße aufweisen, die sich durch in einem Isolierstoffformkörper ausgebildete Ausnehmungen hindurch strecken und mit dem mindestens einem Modulplattenelement druckkontaktiert sind.

Ein derartiges Leistungshalbleitermodul ist in der Offenlegungsschrift DE 102006006425 A1 beschrieben. Bei diesem bekannten Leistungshalbleitermodul kann die Druckkontaktierung der Kontaktfüße mit dem mindestens einen Modulplattenelement Wünsche offen lassen, weil der Bandabschnitt des zum Isolierstoffformkörper benachbarten Lastanschlusselementes vom Isolierstoffformkörper einen freien Spaltabstand besitzt. Das bedeutet, dass bei diesem bekannten Leistungsableitermodul ein definiertes Blockmaß nicht gegeben ist.

In Kenntnis dieser Gegebenheit liegt der Erfindung die Aufgabe zugrunde, ein Leistungshalbleitermodul der eingangs genannten Art zu schaffen, bei dem auf einfache Weise ein definiertes Blockmaß realisiert ist, so dass der Kontaktabstand der Kontaktfüße zwischen dem Isolierstoffformkörper und dem mindestens einen Modulplattenelement genau definiert ist.

Diese Aufgabe wird bei einem Leistungshalbleitermodul der eingangs genannten Art erfindungsgemäß dadurch gelöst, dass der Bandabschnitt des zum Isolierkörper benachbarten Lastanschlusselementes vom Isolierstoffformkörper durch Abstandselemente definiert beabstandet ist.

Mit Hilfe der Abstandselemente, an welchen der Bandabschnitt des zum Isolierstoffformkörper benachbarten Lastanschlusselementes anliegt bzw. gegen welche der besagte Bandabschnitt im zusammengebauten Zustand des Halbleitermoduls drückt, ergibt sich ein definiertes Blockmaß, mit welchem die Kontaktfüße aus dem Isolierstoffformkörper vorstehen und mit dem mindestens einem Modulplattenelement druckkontaktiert sind.

Dabei können die Abstandselemente am Isolierstoffformkörper und/oder am Bandabschnitt des zum Isolierstoffformkörper benachbarten Lastanschlusselementes ausgebildet sein. Die Abstandselemente sind mit dem Isolierstoffformkörper und/oder mit dem Bandabschnitt des zum Isolierstoffformkörper benachbarten Lastanschlusselementes vorzugsweise materialeinstückig ausgebildet, sie besitzen eine begrenzte Nachgiebigkeit.

Das jeweilige Abstandselement kann als Noppe ausgebildet sein. Die jeweilige Noppe kann im Zentrum eines Federsteges vorgesehen sein, der seitlich durch Schlitze begrenzt ist. Eine andere Möglichkeit besteht darin, dass die jeweilige Noppe im Zentrum einer Anzahl von in Umfangsrichtung gleichmäßig verteilten Federstegen vorgesehen ist. Dabei können die Federstege radial geradlinig oder radial spiralförmig gekrümmt ausgebildet sein.

Noch eine andere Möglichkeit besteht darin, dass das jeweilige Abstandselement als gewölbter, seitlich durch Schlitze begrenzter Abstandsstreifen ausgebildet ist. Der Abstandsstreifen kann an seinen beiden voneinander abgewandten Endabschnitten jeweils mit mindestens einem Querschlitz oder zweckmäßigerweise mit einem Paar entgegengesetzt orientierten Querschlitzen ausgebildet sein.

Bei dem erfindungsgemäßen Leistungshalbleitermodul kann der Isolierstoffformkörper ein vom Gehäuse getrennt hergestelltes Bauteil bilden. Eine andere Möglichkeit besteht darin, dass der Isolierstoffformkörper mit dem Gehäusematerial einstückig ausgebildet ist. Bei einer solchen Ausbildung der zuletzt genannten Art kann der Isolierstoffformkörper einen Boden des Gehäuses bilden, an dessen Innenseite sich die Lastanschlusselemente und an dessen Außenseite sich das mindestens eine Modulplattenelement befindet.

Das mindestens eine Modulplattenelement ist in an sich bekannter Weise mit einem Kühlkörper wärmeableitend verbindbar bzw. verbunden. Eine Presseinrichtung kann zum Verschluss des Gehäuses vorgesehen sein, die zur Druckkontaktierung der Last- und Hilfsanschlusselemente mit dem mindestens einen Modulplattenelement vorgesehen ist.

Weitere Einzelheiten, Merkmale und Vorteil ergeben sich aus der nachfolgenden Beschreibung eines in der Zeichnung dargestellten Ausführungsbeispieles des erfindungsgemäßen Leistungshalbleitermoduls.

Es zeigt:
- Figur 1: einen Schnitt durch eine schematisch dargestellte Ausführungsform des Leistungshalbleitermoduls - gemeinsam mit einem stark vergrößerten Detail zur Verdeutlichung einer Abstandsnoppe,
- Figur 2: eine perspektivische Explosionsdarstellung wesentlicher Einzelheiten einer Ausbildung des Leistungshalbleitermoduls,
- Figur 3: perspektivisch einen Abschnitt zur Verdeutlichung einer ersten Ausbildung eines Abstandselementes,
- Figur 4: eine Ansicht in Blickrichtung des Pfeiles IV in Figur 3,
- Figur 5: einen Schnitt entlang der Schnittlinie V-V in Figur 4,
- Figur 6: perspektivisch einen Abschnitt zur Verdeutlichung einer anderen Ausbildung eines Abstandselementes,
- Figur 7: eine Ansicht in Blickrichtung des Pfeiles VII in Figur 6,
- Figur 8: einen Schnitt entlang der Schnittlinie VIII-VIII in Figur 7,
- Figur 9: perspektivisch einen Abschnitt zur Verdeutlichung noch einer anderen Ausbildung eines Abstandselementes,
- Figur 10: eine Ansicht in Blickrichtung des Pfeiles X in Figur 9,
- Figur 11: einen Schnitt entlang der Schnittlinie XI-XI in Figur 10,
- Figur 12: perspektivisch einen Abschnitt zur Verdeutlichung einer weiteren Ausführungsform eines Abstandselementes
- Figur 13: eine Ansicht in Blickrichtung des Pfeiles XIII in Figur 12,
- Figur 14: einen Schnitt entlang der Schnittlinie XIV-XIV in Figur 13, und
- Figur 15: eine Ausbildung des Leistungshalbleitermoduls in einer aufgeschnittenen Darstellung sowie ein vergrößertes Detail desselben zur Verdeutlichung einer Ausbildung eines Abstandselementes, wie es auch in den Figuren 3, 4 und 5 verdeutlicht ist.

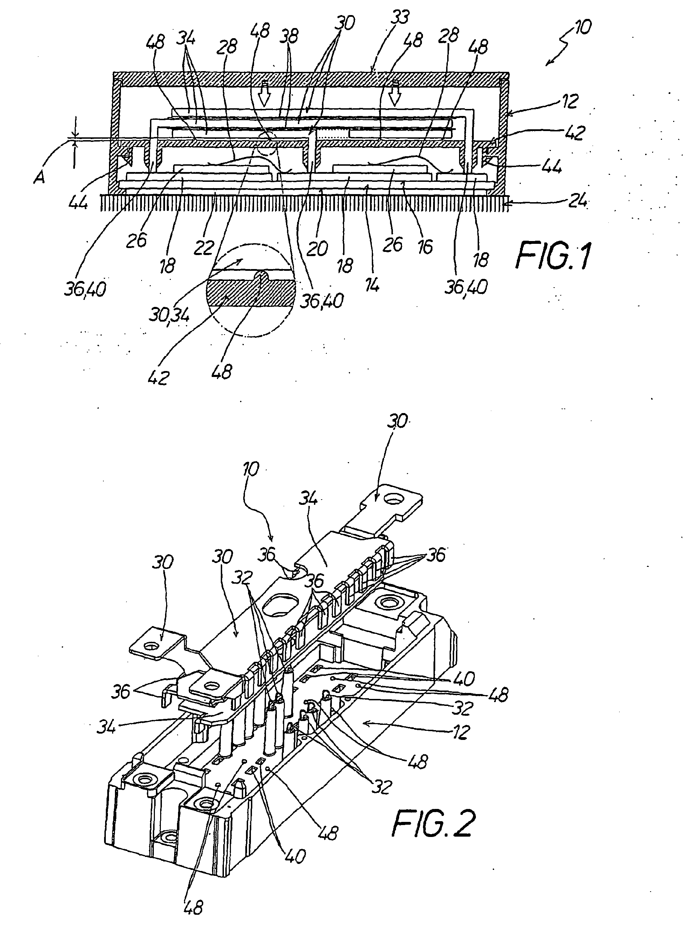

Figur 1 verdeutlicht schematisch eine Ausbildung des Leistungshalbleitermoduls 10 mit einem Gehäuse 12 und einem Modulplattenelement 14, das an seiner einen Hauptfläche 16 strukturierte Metallisierungen 18 und auf seiner gegenüberliegenden zweiten Hauptfläche 20 eine Metallisierung 22 aufweist.

Mit der Bezugsziffer 24 ist ein Kühlkörper bezeichnet, an welchem das Modulplattenelement 14 mit seiner Metallisierung 22 großflächig anliegt, um Verlustwärme vom Modulplattenelement 14 in den Kühlkörper 24 zu transferieren.

Das Modulplattenelement 14 weist Halbleiterbauelemente 26 auf, die mit den strukturierten Metallisierungen 18 durch Bonddrähte 28 kontaktiert sind.

Das Modulplattenelement 14 ist mit Lastanschlusselementen 30 und mit Hilfsanschlusselementen 32 (siehe Figur 2) druckkontaktiert. Zu diesem Zweck ist eine Presseinrichtung 33 (siehe Figur 1) vorgesehen, welche die Last- und Hilfsanschlusselemente 30 und 32 gegen die strukturierten Metallisierungen 18 des Modulplattenelementes 14 drückt.

Die Lastanschlusselemente 30 weisen jeweils einen Bandabschnitt 34 und von diesem in die gleiche Richtung wegstehende Kontaktfüße 36 auf. Die Lastanschlusselemente 30 sind mit ihren Bandabschnitten 34 aufeinander angeordnet und gegeneinander durch Isolierlagen 38 elektrisch isoliert.

Die Kontaktfüße 36 der Lastanschlusselemente 30 erstrecken sich durch Ausnehmungen 40 bzw. Führungsschächte, die in einem Isolierstoffformkörper 42 ausgebildet sind.

Bei dem in Figur 1 schematisch verdeutlichten Ausführungsbeispiel des Leistungshalbleitermoduls 10 ist der Isolierstoffformkörper 42 ein vom Gehäuse 12 getrennt hergestelltes Bauteil, das mit dem Gehäuse 12 mit Hilfe von Schnapp-Rastelementen 44 formschlüssig verbunden ist. Dem gegenüber verdeutlicht Figur 2 eine Ausbildung des Leistungshätbleitermoduls 10, bei welchem der Isolierstoffformkörper 42 mit dem Gehäuse 12 materialeinstückig als Boden des Gehäuses 12 ausgebildet ist.

Mit Hilfe der Presseinrichtung 33 (siehe Figur 1) sind die Kontaktfüße 36 der Lastanschlusselemente 30 und die Hilfsanschlusselemente 32, wie sie in Figur 2 dargestellt sind, mit den strukturierten Metallisierungen 18 des Modulplattenelementes 14 druckkontaktiert.

Um zwischen dem Bandabschnitt 34 des zum Isolierstoffformkörper 32 benachbarten Lastanschlusselementes 30 und dem Isolierstoffformkörper 42 einen definierten Abstand d.h. ein definiertes Blockmaß A (siehe Figur 1) zu realisieren, sind zwischen dem Isolierstoffformkörper 42 und dem besagten Bandabschnitt 34 Abstandselemente 48 vorgesehen. Eines dieser Abstandselemente 48 ist in der Detaildarstellung der Figur 1 in einem größeren Maßstab gezeichnet.

Das jeweilige Abstandselement 48 ist als Noppe ausgebildet. Die Noppen stehen vom Isolierstoffformkörper 42 materialeinstückig weg. Sie besitzen eine begrenzte Nachgiebigkeit.

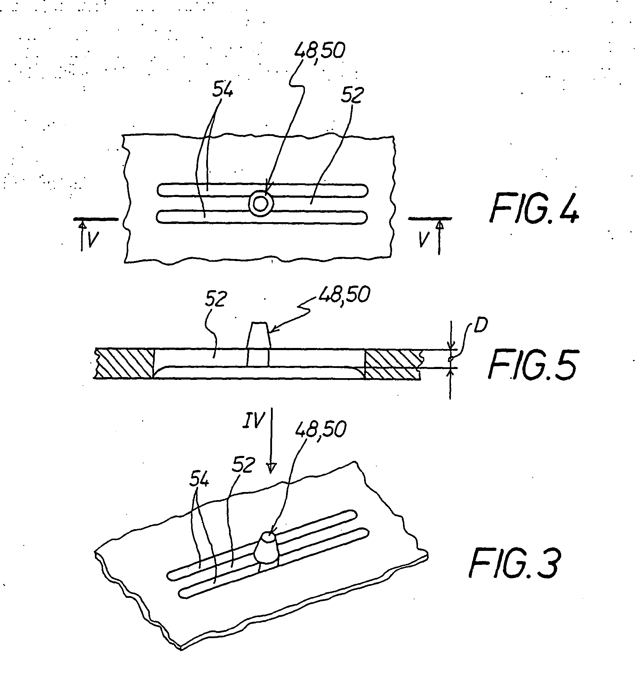

Die Figuren 3, 4 und 5 verdeutlichen eine Ausbildung eines Abstandselementes 48 in Gestalt einer Noppe 50, die im Zentrum eines Federsteges 52 vorgesehen ist und von diesem wegsteht. Der Federsteg 52 ist seitlich durch Schlitze 54 begrenzt. Der Federsteg 52 besitzt eine Dicke D (siehe Figur 5), die kleiner ist als die Dicke des Körpers, an welchem das besagte Abstandselement 48 vorgesehene ist. Bei diesem Körper handelt es sich um den Isolierstoffformkörper 42 oder um den Bandabschnitt 34 des zum Isolierstoffformkörper 42 benachbarten Lastanschlusselementes 30.

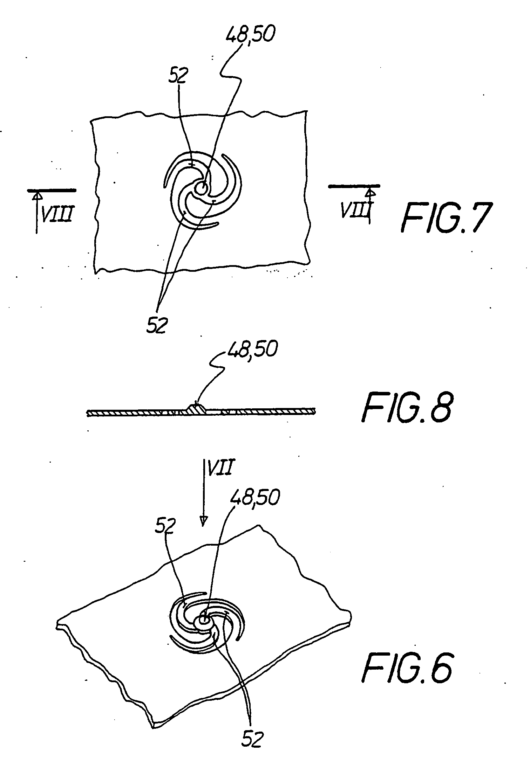

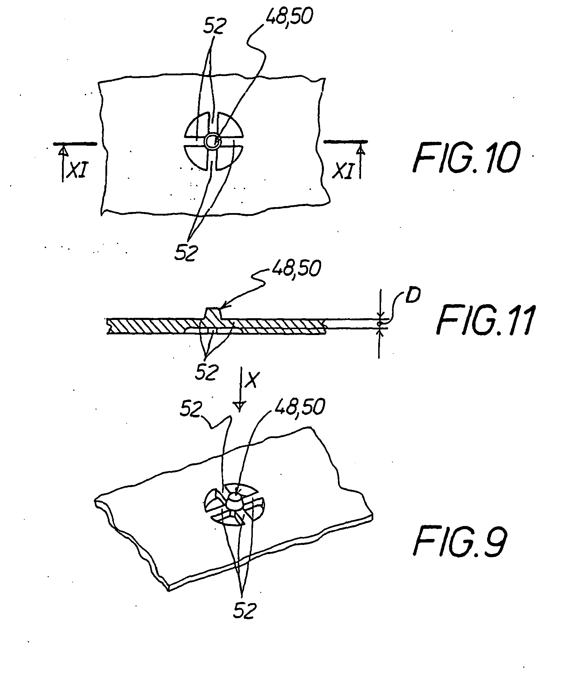

Die Figuren 6, 7 und 8 verdeutlichen eine Ausbildung eines Abstandselementes 48 in Form einer Noppe 50, die im Zentrum einer Anzahl Federstege 52 vorgesehen ist. Bei dieser Ausführungsform sind die in Umfangsrichtung gleichmäßig verteilt vorgesehenen Federstege 52 spiralförmig gekrümmt ausgebildet. Im Vergleich hierzu verdeutlichen die Figuren 9, 10 und 11 eine Ausbildung, bei der das von einer Noppe 50 gebildete Abstandselement 48 im Zentrum von Federstegen 52 vorgesehen ist, die in Umfangsrichtung gleichmäßig verteilt geradlinig ausgebildet sind. Auch bei dieser zuletzt genannten Ausführungsform besitzen die Federstege 52 eine Dicke D, die kleiner ist als die Dicke des Körpers, von welchem das Abstandselement 48 wegsteht. Bei diesem Körper handelt es sich um den Isolierstoffformkörper 42 oder um den Bandabschnitt 34 des zum lsolierstoffformkörper 42 benachbarten Lastanschlusselementes 30.

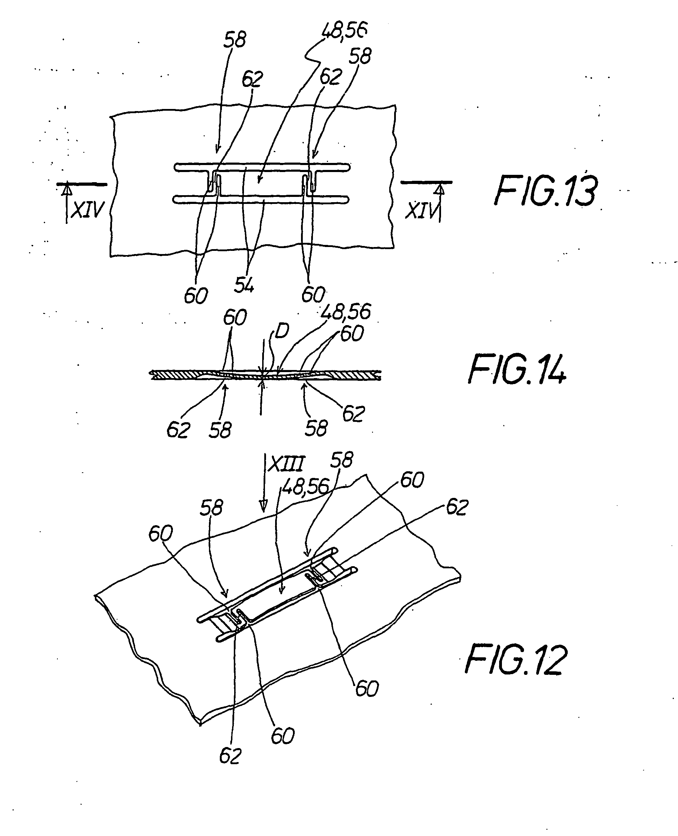

Die Figuren 12, 13 und 14 verdeutlichen eine Ausführungsform eines Abstandselementes 48, das von einem gewölbten Abstandsstreifen 56 gebildet ist. Der Abstandsstreifen 56 ist seitlich durch Längsschlitze begrenzt und an seinen beiden voneinander abgewandten Endabschnitten 58 jeweils mit einem Paar entgegengesetzt orientierten Querschlitzen 60 ausgebildet, durch die jeweils ein nachgiebiger Verbindungssteg 62 bestimmt ist. Die Dicke D des gewölbten Abstandsstreifen 56 ist kleiner als die Dicke des mit dem gewölbten Abstandsstreifen 56 ausgebildeten Körpers. Bei diesem Körper handelt es sich um den Isolierstoffformkörper 42 oder um den Bandabschnitt 34 des zum Isolierstoffkörper 42 benachbarten Lastanschlusselementes 30.

Der gewölbte Abstandsstreifen 56 ist seitlich durch Schlitze 54 begrenzt.

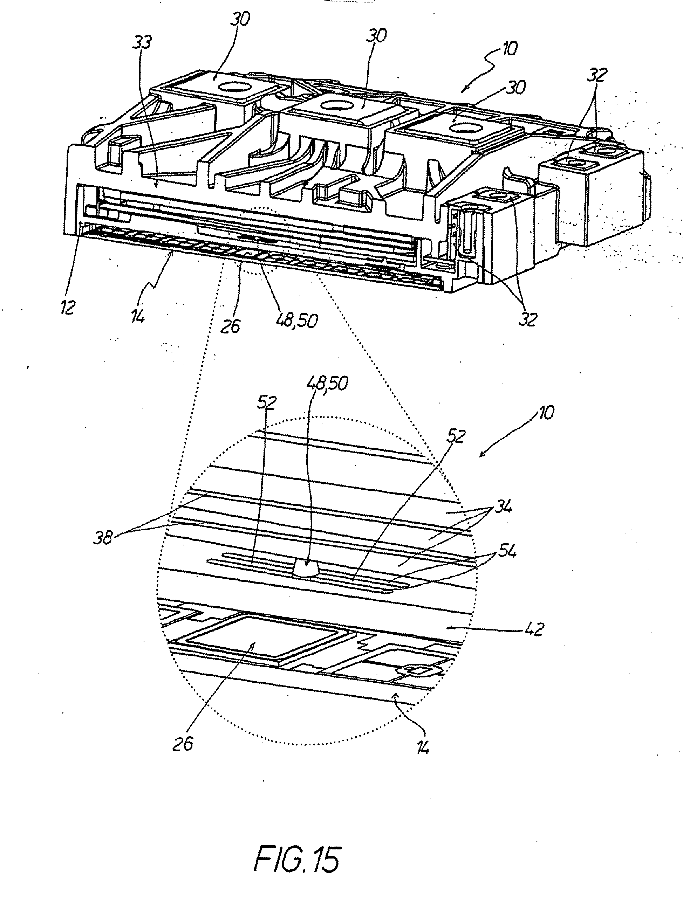

Die Figur 15 verdeutlicht aufgeschnitten eine Ausbildung des Leistungshalbleitermoduls 10, sowie ein vergrößertes Detail des selben, wobei gleiche Einzelheiten mit den selben Bezugsziffern bezeichnet sind, wie in den Figuren 1 bis 14.

### Bezugsziffernliste:

- 10: Leistungshalbleitermodul
- 12: Gehäuse (von 10)
- 14: Modulplattenelement (von 10)
- 16: erste Hauptfläche (von 14)
- 18: Metallisierungen (an 16)
- 20: zweite Hauptfläche (von 14)
- 22: Metallisierung (an 20)
- 24: Kühlkörper
- 26: Halbleiterbauelemente (von 14 an 16)
- 28: Bonddrähte (für 26)
- 30: Lastanschlusselemente (von 10)
- 32: Hilfsanschlusselemente (von 10)
- 33: Presseinrichtung (von 10)
- 34: Bandabschnitt (von 30)
- 36: Kontaktfüße (von 30)
- 38: Isolierlagen (zwischen 34 und 34)
- 40: Ausnehmungen bzw. Schächte (in 42 für 36)
- 42: Isolierstoffformkörper (von 10)
- 44: Schnapp-Rastelemente (von 42)
- 48: Abstandselement (zwischen 34 und 42)
- 50: Noppe (von 48)
- 52: Federsteg (für 50)
- 54: Schlitze (für 52)
- 56: gewölbter Abstandsstreifen (für 48)
- 58: Endabschnitt (von 56)
- 60: Querschlitze (bei 58)
- 62: Verbindungssteg (zwischen 60 und 60)

## Patentansprüche

1. Leistungshalbleitermodul (10) mit einem Gehäuse (12) und mindestens einem mit Halbleiterbauelementen (26) bestückten Modulplattenelement (14), das mit Lastanschlusselementen (30) druckkontaktiert ist, wobei die Lastanschlusselemente (30) aufeinander angeordnete und gegeneinander elektrisch isolierte Bandabschnitte (34) und von diesen in die gleiche Richtung wegstehende Kontaktfüße (36) aufweisen, die sich durch in einem Isolierstoffformkörper (42) ausgebildete Ausnehmungen (40) hindurch erstrecken und mit dem mindestens einem Modulplattenelement (14) druckkontaktiert sind,
und wobei
der Bandabschnitt (34) des zum Isolierstoffformkörper (42) benachbarten Lastanschlusselementes (30) vom Isolierstoffformkörper (42) durch Abstandselemente (48) beabstandet ist.

2. Leistungshalbleitermodul nach Anspruch 1,
**dadurch gekennzeichnet,**
**dass** die Abstandselemente (48) am Isolierstoffformkörper (42) und/oder am Bandabschnitt (34) des zum Isolierstoffformkörper (42) benachbarten Lastanschlusselementes (30) ausgebildet sind.

3. Leistungshalbleitermodul nach Anspruch 1 oder 2,
**dadurch gekennzeichnet,**
**dass** die Abstandselemente (48) eine begrenzte Nachgiebigkeit besitzen.

4. Leistungshalbleitermodul nach einem der Ansprüche 1 bis 3,
**dadurch gekennzeichnet,**
**dass** das jeweilige Abstandselement (48) als Noppe (50) ausgebildet ist.

5. Leistungshalbleitermodul nach Anspruch 4,
**dadurch gekennzeichnet,**
**dass** die jeweilige Noppe (50) von mindestens einem Federsteg (52) wegsteht.

6. Leistungshalbleitermodul nach Anspruch 5,
**dadurch gekennzeichnet,**
**dass** die jeweilige Noppe (50) im Zentrum eines Federsteges (52) vorgesehen ist, der seitlich durch Schlitze (54) begrenzt ist.

7. Leistungshalbleitermodul nach Anspruch 5,
**dadurch gekennzeichnet,**
**dass** die jeweilige Noppe (50) im Zentrum einer Anzahl von in Umfangsrichtung gleichmäßig verteilten Federstegen (52) vorgesehen ist.

8. Leistungshalbleitermodul nach Anspruch 7,
**dadurch gekennzeichnet,**
**dass** die Federstege (52) radial geradlinig oder radial spiralförmig gekrümmt ausgebildet sind.

9. Leistungshalbleitermodul nach einem der Ansprüche 1 bis 3,
**dadurch gekennzeichnet,**
**dass** das jeweilige Abstandselement (48) als gewölbter Abstandsstreifen (56) ausgebildet ist und dieser an seinen beiden voneinander abgewandten Endabschnitten (58) jeweils ein Paar Querschlitze (60) aufweist.

10. Leistungshalbleitermodul nach einem der Ansprüche 1 bis 9,
**dadurch gekennzeichnet,**
**dass** der Isolierstoffformkörper (42) mit dem Gehäuse (12) materialeinstückig ausgebildet ist und dieser Isolierstoffformkörper (42) einen Boden (46) des Gehäuses (12) bildet.

## Claims

1. A power semiconductor module (10) comprising a housing (12) and at least one module board element (14) equipped with semiconductor components (26), which is pressure-contacted with load connection elements (30), wherein the load connection elements (30) comprise strip sections (34) disposed one upon the other and electrically insulated with respect to one another and contact feet (36) which project from these sections in the same direction, said contact feet extending through recesses (40) formed in an insulating material shaped body (42) and being pressure-contacted with the at least one module board element (14) and wherein the strip section (34) of the load connection element (30) adjacent to the insulating material shaped body (42) is spaced apart from the insulating material shaped body (42) by means of spacer elements (48).

2. The power semiconductor module according to claim 1, **characterised in that** the spacer elements (48) are formed on the insulating material shaped body (42) and/or on the strip section (34) of the load connection element (30) adjacent to the insulating material shaped body (42).

3. The power semiconductor module according to claim 1 or 2, **characterised in that** the spacer elements (48) possess a restricted resilience.

4. The power semiconductor module according to any one of claims 1 to 3, **characterised in that** the respective spacer element (48) is configured as a pimple (50).

5. The power semiconductor module according to claim 4, **characterised in that** the respective pimple (50) projects from at least one spring bar (52).

6. The power semiconductor module according to claim 5, **characterised in that** the respective pimple (50) is provided at the centre of a spring bar (52) which is delimited laterally by slots (54).

7. The power semiconductor module according to claim 5, **characterised in that** the respective pimple (50) is provided at the centre of a number of spring bars (52) distributed uniformly in the circumferential direction.

8. The power semiconductor module according to claim 7, **characterised in that** the spring bars (52) are configured to be radially rectilinearly or radially spirally curved.

9. The power semiconductor module according to any one of claims 1 to 3, **characterised in that** the respective spacer element (48) is configured as an arched spacer strip (56) and this has a pair of transverse slots (60) at its two end sections (58) facing away from one another.

10. The power semiconductor module according to any one of claims 1 to 9, **characterised in that** the insulating material shaped body (42) is formed in one material piece with the housing (12) and this insulating material shaped body (42) forms a base (46) of the housing (12).

## Revendications

1. Module semiconducteur de puissance (10) avec un boîtier (12) et au moins un élément modulaire en forme de plaquette (14) équipé d'éléments semiconducteurs (26), qui est mis en contact par pression avec des éléments de raccordement de charges (30), dans lequel les éléments de raccordement de charges (30) sont des segments de ruban (34) disposés les uns sur les autres et électriquement isolés entre eux et possèdent des pattes de contact (36) qui s'en éloignent dans la même direction, qui s'étendent au travers d'ouvertures (40) ménagées dans un corps moulé en matière isolante (42) et qui sont mises en contact par pression avec ledit au moins un élément modulaire en forme de plaquette (14) ; et
dans lequel le segment de ruban (34) de l'élément de raccordement de charge (30) adjacent au corps moulé en matière isolante (42) est écarté du corps moulé en matière isolante (42) par des éléments d'écartement (48).

2. Module semiconducteur de puissance selon la revendication 1, **caractérisé en ce que** les éléments d'écartement (48) sont formés sur le corps moulé en matière isolante (42) et/ou sur le segment de ruban (34) de l'élément de raccordement de charge (30) adjacent au corps moulé en matière isolante (42).

3. Module semiconducteur de puissance selon la revendication 1 ou 2, **caractérisé en ce que** les éléments d'écartement (48) possèdent une souplesse limitée.

4. Module semiconducteur de puissance selon l'une des revendications 1 à 3, **caractérisé en ce que** les différents éléments d'écartement (48) prennent la forme de tétons (50).

5. Module semiconducteur de puissance selon la revendication 4, **caractérisé en ce que** les différents tétons (50) font saillie d'au moins une nervure élastique (52).

6. Module semiconducteur de puissance selon la revendication 5, **caractérisé en ce que** les différents tétons (50) sont prévus au centre d'une nervure élastique (52) qui est délimitée latéralement par des fentes (54).

7. Module semiconducteur de puissance selon la revendication 5, **caractérisé en ce que** les différents tétons (50) sont prévus au centre d'un certain nombre de nervures élastiques (52) distribuées régulièrement sur la circonférence.

8. Module semiconducteur de puissance selon la revendication 7, **caractérisé en ce que** les nervures élastiques (52) prennent une forme rectiligne radialement ou recourbée radialement en forme de spirale.

9. Module semiconducteur de puissance selon l'une des revendications 1 à 3, **caractérisé en ce que** les différents éléments d'écartement (48) prennent la forme de rubans voûtés d'écartement (56) et que ceux-ci portent à leur deux sections d'extrémité (58) opposées l'une à l'autre une paire de fentes transversales (60).

10. Module semiconducteur de puissance selon l'une des revendications 1 à 9, **caractérisé en ce que** le corps moulé en matière isolante (42) est fabriqué d'une seule pièce avec le boîtier (12) et **en ce que** ce corps moulé en matière isolante (42) constitue un fond (46) du boîtier (12).
